# EUROPEAN PATENT SPECIFICATION

(11) **EP 4 055 377 B1**
(45) Date of publication and mention of the grant of the patent: **31.12.2025**
(21) Application number: 20884030.6
(22) Date of filing: 06.11.2020
(51) Int. Cl.: C23C 14/08, C23C 16/02, C23C 16/26, C23C 28/04, G01N 27/30, G01N 27/48, G01N 27/416

(54) **A MULTI-LAYERED ELECTRODE FOR SENSING PH**
MEHRSCHICHTIGE ELEKTRODE ZUR PH-MESSUNG
ÉLECTRODE MULTICOUCHE POUR LA DÉTECTION DU PH

(30) Priority: 06.11.2019 AU 2019904170
(43) Date of publication of application: 14.09.2022
(73) Proprietor: Commonwealth Scientific and Industrial Research Organisation, Acton, Australian Capital Territory 2601 (AU)
(72) Inventor: VEPSÄLÄINEN, Mikko, Kalevi, Chadstone, Victoria 3148 (AU); BENDAVID, Abraham, Eliahu, North Bondi, New South Wales 2026 (AU)
(74) Representative: Müller, Christian Stefan Gerd
(86) International application number: PCT/AU2020/051210
(87) International publication number: WO 2021/087569

(56) References cited:
- CN-A- 109 001 273
- US-A1- 2017 336 351
- LONSDALE W. ET AL: "Manufacture and application of RuO2 solid-state metal-oxide pH sensor to common beverages", TALANTA, vol. 180, 22 December 2017 (2017-12-22), NL, pages 277 - 281, XP093090844, ISSN: 0039-9140, DOI: 10.1016/j.talanta.2017.12.070
- SCHITTHELM FRANK ET AL: "Electronic characterization of thin diamondlike carbon films for pH sensor applications", PROCEEDINGS OF THE SPIE, vol. 3539, 18 December 1998 (1998-12-18), US, pages 139 - 146, XP055822348, ISSN: 0277-786X, ISBN: 978-1-5106-5738-0, DOI: 10.1117/12.333742
- KUO LI-MIN ET AL: "A precise pH microsensor using RF-sputtering IrO2and Ta2O5films on Pt-electrode", SENSORS AND ACTUATORS B: CHEMICAL, ELSEVIER BV, NL, vol. 193, 16 December 2013 (2013-12-16), pages 687 - 691, XP028818829, ISSN: 0925-4005, DOI: 10.1016/J.SNB.2013.11.109
- KUO, LI-MIN ET AL.: "A precise pH microsensor using RF-sputtering Ir02 and Ta205 films on Pt-electrode", SENSORS AND ACTUATORS B: CHEMICAL, vol. 193, 2014, pages 687 - 691, XP028818829, DOI: 10.1016/j.snb.2013.11.109
- SCHITTHELM, FRANK ET AL.: "Electronic characterization of thin diamondlike carbon films for pH sensor applications", CHEMICAL MICROSENSORS AND APPLICATIONS, vol. 3539, 1998, XP055822348
- LONSDALE, WADE, DEVELOPMENT, MANUFACTURE AND APPLICATION OF A SOLID STATE PH SENSOR USING RUTHENIUM OXIDE, 2018, XP055822350
- SEBASTIAN CHALUPCZOK, PETER KURZWEIL, JOSEF SCHOTTENBAUER, CHRISTIAN SCHELL, ALFRED LECHNER, MARC PÖPPEL: "A capacitive pH sensor based on ruthenium dioxide: Manufacture and testing of the interdigital structure", TAGUNGSBAND, 2018, pages 159 - 165, XP055928263
- POGHOSSIAN, ARSHAK ET AL.: "Chemical sensor as physical sensor: ISFET-based flow-velocity, flow direction and diffusion-coefficient sensor", SENSORS AND ACTUATORS B: CHEMICAL, vol. 95, no. 1-3, 2003, pages 384 - 390, XP085622343

## Description

### Technical Field

The invention relates to a multi-layered electrode for sensing pH, and in particular to an electrode comprising a metal oxide-based sensing layer on a substrate, a metal oxide-based proton-permeable layer covering the sensing layer, and a carbonaceous layer on the proton-permeable layer comprising amorphous carbon. The invention also relates to a method of producing the multi-layered electrode, to a pH sensor comprising the multi-layered electrode, and to a method of measuring pH with the multi-layered electrode.

### Background of Invention

pH is one of the most commonly measured analytical parameters in laboratories and industry. An accurate measurement of pH is critical in many chemical, minerals and biological processes, including water quality monitoring, chemical and biological analyses, blood monitoring, environmental monitoring and various clinical tests. All of these applications require reliable and accurate pH sensors.

Traditional glass pH probes are still commonly used. However, such devices are not ideal for all applications due to their relatively large size, fragility, need for recalibration, and their incompatibility with high temperature applications and for wet-storage. Therefore, considerable research in recent decades has focused on the development of solid state pH-sensing systems. Solid state pH electrodes employ an active sensing material which is commonly a metal oxide such as iridium dioxide, ruthenium dioxide, osmium dioxide or tin dioxide. Ion Selective Field Effect Transistor (ISFET) type sensors use the pH-sensitive material as the gate electrode, with the resultant current through the transistor correlating to the pH of the analyte in contact with the gate. However, ISFET sensors are limited to pressures of about 2 bars, suffer from drift and hysteresis effects and are sensitive to light. Electrodes suitable for direct potentiometric pH measurements are thus preferred for many applications.

In a metal oxide-based potentiometric pH sensing system, a metal oxide sensing layer on the electrode substrate is exposed to the analyte and its pH-dependent potential is directly measured, relative to the reference potential of a reference electrode, using a potentiostat. However, proton-sensitive metal oxides are vulnerable to redox interference caused by reducing or oxidising species in the analyte, and some oxides also react with halogens forming soluble compounds. This has limited the deployment of these sensors for many applications. Recently, protective coatings formed of an electrically insulating proton-conductive metal oxide or polymer have been used to protect the sensing layer from redox interference. For example, Kuo et al reported the use of an outer tantalum pentoxide layer to protect an iridium-oxide based electrode (Sensors and Actuators B: 2014, 193, 687).

While the use of such proton-permeable layers provides a measure of protection from redox interference, there is a need for further improvements. Moreover, reported metal oxide-based pH electrodes remain unsuitable for many applications due to the relative fragility of the metal oxide and protective layers. Multi-layered metal oxide electrodes are susceptible to physical damage in abrasive analytes, such as minerals processing streams containing particulate material. Biofouling of the electrode surface caused by adhesion and proliferation of microorganisms on the sensor-analyte interface may also limit applications requiring extended periods of use, for example in environmental monitoring applications.

There is therefore an ongoing need for new metal oxide-based potentiometric electrodes for sensing pH, which at least partially address one or more of the above-mentioned short-comings, or provide a useful alternative.

A working electrode for sensing pH, based on the use of laser-etched sputter-deposited RuO₂ on Al₂O₃ substrate, modified with thin layers of sputter deposited Ta₂O₅ and drop-cast Nafion for minimisation of redox interference, is known from Lonsdale et al: "Manufacture and application of RuO2 solid-state metal-oxide pH sensor to common beverages", vol. 180, 22 December 2017, pages 277-281.

### Summary of Invention

The inventors have found that a carbonaceous layer comprising amorphous carbon may advantageously be provided as an outer layer of a multilayered, metal-oxide-based potentiometric electrode for sensing pH. The carbonaceous layer may protect the electrode against mechanical damage and/or fouling in use, and in cooperation with a metal oxide-based proton-permeable layer may protect the underlying sensing layer from redox interference. The carbonaceous layer permits acceptable proton permeability, and thus does not unacceptably reduce the sensitivity of the electrode, even when present as a continuous coating over the underlying metal oxide layers.

In accordance with a first aspect, the invention provides a multi-layered electrode for sensing pH as set out in independent claim 1.

In some embodiments, the carbonaceous layer is a continuous coating which covers at least a portion of the proton-permeable layer.

In some embodiments, the carbonaceous layer has a thickness of less than 500 nm, or between 5 nm and 100 nm, such as between 15 nm and 60 nm.

In some embodiments, the amorphous carbon comprises diamond-like carbon. The amorphous carbon may comprises at least 10 % sp³-hybridised carbon of the total carbon, such as from 20 % to 85 % sp³-hybridised carbon of the total carbon. In some embodiments, the carbonaceous layer is formed by plasma enhanced chemical vapour deposition.

In some embodiments, the proton-conductive metal oxide is selected from the group consisting of tantalum pentoxide, yttrium stabilised zirconia, yttrium-doped barium cerate, barium cerium yttrium zirconate and gadolinium oxide doped cerium oxide. In some embodiments, the proton-conductive metal oxide comprises tantalum pentoxide or yttrium stabilized zirconia.

In some embodiments the proton-sensitive metal oxide is selected from the group consisting of ruthenium oxide (RuO₂), platinum oxide (PtO₂), iridium oxide (IrO₂), osmium oxide (OsO₂), tin oxide (SnO₂), titanium oxide (TiO₂), antimony oxide (Sb₂O₃), rhodium oxide (RhO₂), and palladium oxide (PdO). In some embodiments, the proton-sensitive metal oxide comprises ruthenium oxide.

In some embodiments, the substrate comprises an electrically conductive material such that the electrically conductive connection passes through or along the substrate. The electrically conductive material may comprise a semiconductor, such as doped silicon. In some embodiments, the substrate comprises a semiconductor wafer having a first side, a second side and a thickness of between 300 µm and 3 mm, such as between 400 µm and 700 µm, wherein the sensing layer is disposed on the first side and the pH-dependent potential of the multi-layered electrode is measurable through the second side.

In some embodiments, the sensing layer has a thickness of between 200 nm and 1000 nm, such as between 250 nm and 500 nm. In some embodiments, the proton-permeable layer has a thickness of between 10 nm and 100 nm, such as between 15 nm and 60 nm.

In some embodiments, the sensing layer and the proton-permeable layer are formed by sputtering, such as RF magnetron sputtering.

In accordance with a second aspect, the invention provides a pH sensor as set out in dependent claim 9, comprising the claimed multi-layered electrode, a reference electrode, and means for measuring the difference between the pH-dependent potential of the multi-layered electrode and a reference potential of the reference electrode. The means may be a potentiostat or a voltmeter.

In accordance with a third aspect, the invention provides a method of measuring pH as set out in independent claim 10.

In some embodiments, the analyte comprises abrasive particulate material and/or has a pH of below 4. In some embodiments the analyte is a leachate or a leach slurry from a mineral leaching process or an acid mine drainage stream.

In accordance with a fourth aspect, the invention provides a method of producing a multi-layered electrode for sensing pH as set out in independent claim 12.

In some embodiments, forming the carbonaceous layer comprises depositing amorphous carbon on the proton-permeable layer by plasma enhanced chemical vapour deposition.

In some embodiments, forming the sensing layer comprises depositing the proton-sensitive metal oxide on the substrate by sputtering, such as magnetron sputtering, for example RF magnetron sputtering.

In some embodiments, forming the proton-permeable layer comprises depositing the electrically insulating proton-conductive metal oxide on the sensing layer by sputtering, such as magnetron sputtering, for example RF magnetron sputtering.

In some embodiments, the substrate comprises a conductive material, such as a semiconductor, for example doped silicon, such that the electrically conductive connection passes through or along the substrate. The substrate may comprise a semiconductor wafer having a first side, a second side and a thickness of between 300 µm and 3 mm, such as between 400 µm and 700 µm, wherein the sensing layer is formed on the first side.

In some embodiments, the proton-conductive metal oxide is selected from the group consisting of tantalum pentoxide, tantalum pentoxide, yttrium stabilised zirconia, yttrium-doped barium cerate, barium cerium yttrium zirconate and gadolinium oxide doped cerium oxide.

In some embodiments, the proton-sensitive metal oxide is selected from the group consisting of ruthenium oxide (RuO₂), platinum oxide (PtO₂), iridium oxide (IrO₂), osmium oxide (OsO₂), tin oxide (SnO₂), titanium oxide (TiO₂), antimony oxide (Sb₂O₃), rhodium oxide (RhO₂), and palladium oxide (PdO).

Where the terms "comprise", "comprises" and "comprising" are used in the specification (including the claims) they are to be interpreted as specifying the stated features, integers, steps or components, but not precluding the presence of one or more other features, integers, steps or components, or group thereof.

As used herein, the terms "first", "second", "third" etc in relation to various features of the disclosed devices are arbitrarily assigned and are merely intended to differentiate between two or more such features that the device may incorporate in various embodiments. The terms do not of themselves indicate any particular orientation or sequence. Moreover, it is to be understood that the presence of a "first" feature does not imply that a "second" feature is present, the presence of a "second" feature does not imply that a "first" feature is present, etc.

Further aspects of the invention appear below in the detailed description of the invention.

### Brief Description of Drawings

Embodiments of the invention will herein be illustrated by way of example only with reference to the accompanying drawings in which:
Figure 1 is a schematic depiction of a multi-layered electrode for sensing pH, according to an embodiment of the invention.
Figure 2 is a schematic depiction of a multi-layered electrode for sensing pH, according to another embodiment of the invention.
Figure 3 is a schematic depiction of a deposition apparatus for forming a diamond-like carbon thin film via plasma-enhanced chemical vapour deposition.
Figure 4 is an X-Ray diffraction pattern of a crystalline RuO₂ thin film produced on a silicon substrate via RF-magnetron sputtering at 220°C in Example 1.
Figure 5 is an XPS spectrum of a RuO₂ thin film produced on a silicon substrate via RF-magnetron sputtering at 220°C in Example 1.
Figure 6 is an XPS spectrum of a Ta₂O₅ thin film produced over an RuO₂-coated silicon substrate in Example 1.
Figure 7 depicts plots of electrode potential as a function of pH for Si-RuO₂-Ta₂O₅ electrodes having various different RuO₂ film thicknesses, as measured in Example 3.
Figure 8 depicts plots of electrode potential as a function of pH for Si-RuO₂-Ta₂O₅ and Si-RuO₂-YSZ electrodes, as measured in Example 4.
Figure 9 depicts comparative plots of electrode potential as a function of pH for Si-RuO₂-Ta₂O₅-amorphous carbon and Si-RuO₂-Ta₂O₅ multi-layered electrodes, as measured in Example 5.
Figure 10 depicts the electrode potential response of a Si-RuO₂-Ta₂O₅-amorphous carbon multi-layered electrode in pH 1 to pH 10 buffer solutions, as measured in Example 5.
Figure 11 depicts the electrode potential response of a Si-RuO₂-Ta₂O₅-amorphous carbon multi-layered electrode in pH 2 buffer solutions having Fe²⁺ concentrations varying from 0.001M to 1M, as measured in Example 6.
Figure 12 depicts the electrode potential responses of Si-RuO₂-Ta₂O₅-amorphous carbon and Si-RuO₂-Ta₂O₅ multi-layered electrodes in pH 2 buffer solutions having ascorbic acid concentrations varying from 0M to 10M, as measured in Example 6.
Figure 13 depicts comparative plots of electrode potential as a function of pH for Si-RuO₂-Ta₂O₅-amorphous carbon and Si-RuO₂-amorphous carbon multi-layered electrodes, as measured in Example 7.
Figure 14 depicts comparative plots of electrode potential as a function of pH for Si-RuO₂-YSZ-amorphous carbon and Si-RuO₂-YSZ multi-layered electrodes, as measured in Example 8.
Figure 15 depicts comparative plots of electrode potential as a function of pH for Si-RuO₂-YSZ multi-layered electrodes, with continuous and discontinuous RuO₂ layers, as measured in Example 9.
Figure 16 depicts comparative plots of electrode potential as a function of pH for Si-RuO₂-YSZ multi-layered electrodes, with varying thicknesses of the YSZ layer, as measured in Example 10.

### Detailed Description

The present invention relates to a multi-layered electrode for sensing pH. The electrode comprises a sensing layer comprising at least one proton-sensitive metal oxide on a substrate, a proton-permeable layer comprising at least one electrically insulating proton-conductive metal oxide which covers at least the analyte-contact portion of the sensing layer, and a carbonaceous layer comprising amorphous carbon on the proton-permeable layer. When the electrode is exposed to an aqueous analyte, the proton-permeable and carbonaceous layers permit sufficient conductivity of protons to the underlying sensing layer, and the resultant pH-dependent potential of the electrode is measured via an electrically conductive connection to the sensing layer.

In at least some embodiments, the carbonaceous layer present at the electrode surface provides a mechanically hard and fouling-resistant electrode-analyte interface which may protect the electrolyte from physical damage such as abrasion and/or fouling such as biofouling during use. The carbonaceous and proton-permeable layers together may also protect the sensing layer from reducing or oxidising species in the analyte which would otherwise confound the pH measurement.

### Sensing layer

The sensing layer comprises, and in some embodiments consists of, at least one proton-sensitive metal oxide. As used herein, a proton-sensitive metal oxide is a metal oxide which, when exposed to an aqueous solution, exhibits a redox potential (electrode potential) that is dependent on the hydrogen ion (proton) concentration in the solution. The proton-sensitive metal oxide is also sufficiently electrically conductive to allow the electrode potential to be transmitted for measurement. A wide range of metal oxides are reported to be suitable for application in solid state pH sensing electrodes, and it is contemplated that any of these metal oxides may be used. In some embodiments, the sensing layer comprises at least one of ruthenium oxide (RuO₂), platinum oxide (PtO₂), iridium oxide (IrO₂), osmium oxide (OsO₂), tin oxide (SnO₂), titanium oxide (TiO₂), antimony oxide (Sb₂O₃), rhodium oxide (RhO₂), and palladium oxide (PdO). RuO₂, IrO₂ and SnO₂ are particularly favoured for metal oxide pH sensing applications due to their chemical stability and high conductivity. Combinations of metal oxides, for example a nanocomposite of RuO₂ and Ta₂O₅, in the sensing layer are also contemplated. The metal oxide sensing layer may suitably be crystalline or amorphous. For example, it has been found that both highly crystalline and substantially amorphous RuO₂ layers provide good sensitivity to pH.

In some embodiments, the sensing layer is a thin film, for example having a thickness of between 200 nm and 1000 nm, such as between 250 nm and 500 nm. Thin film metal oxide layers may be fabricated by a variety of methodologies, including sputter deposition techniques as will be described in greater detail hereafter. The layer may be a continuous film of the metal oxide deposited on a portion of the substrate; however, it is not excluded that the layer may be patterned or otherwise formed discontinuously on the substrate provided that a pH dependent potential can be measured. The sensing layer may alternatively be thicker than 1000 nm; in this case conductive additives such as particulate conductive carbon may optionally be included together with the metal oxide.

### Substrate and electrical connection

The substrate may in principle be any substrate capable of bearing the multi-layer structure of the electrode. The substrate may be electrically conductive or insulating subject to the requirement that an electrically conductive connection to the sensing layer is provided such that the pH-dependent potential of the multi-layered electrode can be measured. The substrate may thus comprise a metal, a semiconductor or an insulator, including polymers and ceramics.

In some embodiments, the substrate comprises an electrically conductive material, such as a metal or a semiconductor, in at least a surface layer of the substrate. Advantageously, this may provide the opportunity to measure the pH-dependent potential of the electrode's sensing layer via a conductive pathway extending through the substrate or along the substrate surface. Suitable electrically conducting substrates may include those formed from semi-conductive silicon, stainless steel, platinum, gold, glassy carbon or pyrolytic graphite, or substrates comprising a thin conductive surface film of indium tin oxide, fluorine-doped tin oxide, aluminium-doped zinc oxide or the like.

In some embodiments, the substrate comprises a semiconductor, for example a doped silicon such as n-type silicon. Such substrates have been found to provide a good balance of properties for the multi-layer electrodes of the invention. These properties include chemical inertness in aqueous analytes, in particular to redox reactions which could undesirably interfere with the pH measured at the sensing layer, compatibility with thin film deposition techniques for fabricating the successive functional layers of the electrode, and suitable electrical conductivity to allow the sensing layer potential to be measured through the substrate material.

In some embodiments, the substrate comprises a semiconductor wafer, for example a doped silicon semiconductor wafer. The wafer may have a thickness of between 300 µm and 3 mm, such as between 400 µm and 700 µm. The wafer may have a resistivity in the range of 0.0008 to 0.02 ohm.cm. The sensing layer is typically disposed on one surface of the wafer only, and the pH-dependent potential of the sensing layer may then be measured via a conductive pathway extending through the thickness of the substrate and the reverse surface of the wafer. Advantageously, this construction avoids the need to fabricate a separate conductive track on the substrate surface, and allows the electrical connection between the electrode and the external circuit of a pH sensing system to be physically isolated from contact with the analyte by the wafer.

The electrode comprises an electrically conductive connection to the sensing layer by which the electrode's pH-dependent potential can be measured, typically at a potentiometer connected to the electrode. As described above, it has been found that the potential can advantageously be measured through a suitably conductive substrate on which the sensing layer is formed. However alternate arrangements are contemplated and fall within the scope of the invention. For example, a conductive metallic track of metal such as platinum can be patterned onto an otherwise insulating substrate, with the sensing layer then deposited onto a portion of the conductive track and the potential measured at another portion. Alternatively, a conductive track can be formed in the sensing layer itself, for example by laser reduction of the proton-sensitive metal oxide. In a further embodiment, a conductive wire can be physically attached to the sensing layer after its formation.

### Proton permeable layer

The multi-layered electrode comprises a proton-permeable layer, comprising at least one electrically insulating proton-conductive metal oxide, which covers at least a portion of the sensing layer. In some embodiments, the proton-permeable layer consists of electrically insulating proton-conductive metal oxide. One role of the metal-oxide based proton-permeable layer is to protect, at least to a degree, the underlying sensing layer from strong oxidising or reducing species present in an analyte which can interfere with the measured potential correlating to pH. It will thus be appreciated that the layer should generally be present as a continuous covering over the entire sensing layer or at least those portions thereof where contact with the analyte is expected. In use, larger redox species are excluded from the sensing layer by the proton-permeable layer, whereas sufficiently facile ionic conduction of the small hydrogen ions is permitted. The inventors have also found that such an intermediate layer is important to obtain a linear pH response when a continuous amorphous carbon layer is present on the electrode. Without wishing to be bound by any theory, it is believed that the electrically insulating proton-permeable layer is required to physically and/or electrically isolate the sensing layer from the carbonaceous layer, so as to prevent interference of the measured electrode potential by the carbonaceous layer.

The proton-conductive metal oxide is electrically insulating, which means that it is a poor electrical conductor, in particular relative to the proton-sensitive metal oxide in the sensing layer of the electrode. The role of the proton-permeable layer and carbonaceous layer, acting in combination, is to protect the underlying sensing layer from interference and damage but not otherwise to contribute directly to the measured potential. Therefore, the electrically insulating properties of the proton-conductive metal oxide ensure that the pH-sensitive response of the device is provided by the sensing layer and not the proton-permeable layer, even if the proton-conductive metal oxide is inherently capable of participating in pH-dependent redox chemistry.

The contrasting electrical conductivities of suitable proton-sensitive metal oxides and proton-conductive metal oxides can be considered by comparing reported resistivity values for these materials. Reported values for the resistivity of RuO₂ thin films are in the range of 20-90 µΩ.cm, whereas those for yttrium stabilised zirconia (YSZ) are in the range of 2.5 x 10⁹ to 1 x 10¹² µΩ.cm and those for Ta₂O₅ are in the range of 9 x 10⁴ to 3 x 10⁶ µΩ.cm. In some embodiments, therefore, the electrically insulating proton-conductive metal oxide in the proton-permeable layer has a resistivity of above 1 x 10³ µΩ.cm, or above 1 x 10⁴ µΩ.cm, or above 1 x 10⁵ µΩ.cm. In some embodiments, the resistivity of the proton-conductive metal oxides in the proton-permeable layer has a resistivity which is higher than that of the proton-sensitive metal oxide in the sensing layer by a factor of 10², or 10³, or 10⁴, or 10⁵.

Proton-permeable layers fabricated from a variety of electrically insulating proton-conductive metal oxides have previously been disclosed for pH sensing applications, and it is contemplated that any of these metal oxides may be used. In some embodiments, the proton-permeable layer comprises at least one proton-conductive metal oxide selected from the group consisting of tantalum pentoxide (Ta₂O₅), yttrium stabilised zirconia (YSZ), yttrium-doped barium cerate (BaCe_{0.2}Y_{0.1}O_{3-δ}; also known as BCYO), barium cerium yttrium zirconate (BaCeO_{0.2}Y_{0.1}Zr_{0.7}O₃) and gadolinium oxide doped cerium oxide (CeO₂-90%-Gd₂O₃-10%). Proton-permeable layers comprising these metal oxide materials can be produced on metal oxide sensing layers by thin film deposition techniques, including magnetron sputtering. Ta₂O₅ and YSZ in particular has been found to be suitable for their protective properties and the ease of depositing these materials by sputtering. Other proton-conductive metal oxides are discussed in chapter 10 of Knauth et al, "Solid State Proton Conductors: Properties and Applications in Fuel Cells", John Wiley and Sons, 2012, which is hereby incorporated by reference.

The metal oxide in the proton-permeable layer may be substantially amorphous. An amorphous metal oxide layer lacks grain boundaries and may thus provide a better protective effect against interfering redox species.

In some embodiments, the proton-permeable layer is a thin film, for example having a thickness of between 10 nm and 100 nm, such as between 15 nm and 60 nm. Such thin film metal oxide layers may be fabricated by a variety of methodologies, including sputter deposition techniques as will be described in greater detail hereafter.

### Carbonaceous layer

The multi-layered electrode according to the invention comprises a carbonaceous layer, comprising amorphous carbon, on the proton-permeable layer. The carbonaceous layer is typically the outermost layer of the electrode, and thus directly exposed to the analyte in use.

Amorphous carbon is a carbon material which lacks a crystalline structure, although some short-range order may be present. In some embodiments, the amorphous carbon comprises diamond-like carbon. As used herein, diamond-like carbon refers to a metastable form of substantially amorphous carbon comprising both sp²- and sp³-hybridised carbon atoms, and includes hydrogen-free, hydrogenated and heteroatom-doped forms.

Diamond-like carbon coatings typically comprise a significant proportion of tetrahedral sp³-bonded carbon atoms, thus establishing a 3D-network of bonding in the material and conferring "diamond-like" properties including high modulus, mechanical hardness and chemical inertness. In some embodiments, therefore, the amorphous carbon of the carbonaceous layer comprises at less 10 % sp³- hybridised carbon of the total carbon, such as from 20-85 %, or from 25 to 50 %. The fraction of sp³- hybridised carbon in diamond-like carbon can be determined by electron energy loss spectroscopy (EELS) or Raman spectroscopy. In some embodiments, the diamond-like carbon of the carbonaceous layer has a hardness of at least 14 GPa, or at least 15 GPa, or at least 16 GPa, such as about 17 GPa, due to its sp³ carbon content. Hardness may be determined by nanoindentation, also known as instrumented indentation testing. This technique is commonly applied for testing mechanical properties of thin film materials.

The character of diamond-like carbon, for example the fraction of sp³ carbon and the hydrogen content, depends on the method of production as will be discussed in greater detail hereafter. In some embodiments, the carbonaceous layer is formed by plasma enhanced chemical vapour deposition. This method typically produces a hydrogenated form of diamond-like carbon, for example with from 30 to 70 % sp³-hybridised carbon of the total carbon and from 20 to 60 mol % hydrogen.

The favourable mechanical properties, chemical inertness, low surface roughness, hydrophobicity and low surface energy of diamond-like carbon makes this an attractive material in various coating applications. Diamond-like carbon coatings have also been used as the proton-sensitive layer in ion-selective field-effect transistor (ISFET) sensors.

In the multi-layer electrodes of the present invention, by contrast, a metal oxide-based sensing layer is utilised and two overlying protective layers are present on the sensing layer. The carbonaceous layer, used in tandem with an underlying proton-permeable metal oxide layer, thus has a different function from previous uses in ISFET sensors, operating by different principles and providing different advantages. It is surprisingly found that a carbonaceous layer comprising amorphous carbon permits acceptable proton permeability, and thus does not unacceptably reduce the sensitivity of the electrode, even when present as a thin continuous coating over the underlying metal oxide layers.

The carbonaceous layer may provide physical protection to the electrode structure by improving the surface mechanical properties, including hardness. Thus, the carbonaceous layer resists abrasion or other damage of the more fragile metal oxide-based layers. This may advantageously extend the electrode lifetime and/or the range of applications of the electrodes, for example to the analysis of highly abrasive leachates or leach slurries in minerals processing applications. In addition, it is expected that the carbonaceous layer will protect the electrode against fouling, and in particular biofouling, in longer term uses. Biofouling is initiated by microbial adhesion to a surface, and can thus be inhibited by altering the surface properties. The low surface energy and hydrophobicity of the carbonaceous layer will inhibit adhesion and proliferation of microorganisms on the electrode surface.

In at least some embodiments, it is also believed that the carbonaceous layer acts in combination with the proton-permeable layer to reduce redox interference at the sensing layer. Without wishing to be bound by theory, the amorphous carbonaceous layer is believed to be selectively permeable to protons while excluding some larger oxidising or reducing species present in the analyte.

In some embodiments, the carbonaceous layer is a continuous coating which covers at least a portion of the proton-permeable layer. In particular, the continuous coating may cover the proton-permeable layer at locations on the electrode where contact with the analyte is expected. Such continuous coatings may have a thickness of between 5 nm and 100 nm, such as between 15 nm and 60 nm. The inventors have found that a continuous diamond-like carbon coating of 50 nm thickness produced little or no reduction in sensitivity of electrodes having RuO₂ sensing layers and Ta₂O₅ or YSZ proton-permeable layers.

In other embodiments, the carbonaceous layer is a discontinuous layer, such that the underlying metal oxide layer may be partially exposed to the analyte in use. A patterned structure, for example comprising regular holes or comprising discrete lines or dots, may be utilized. At least some advantages of the invention, for example resistance to abrasion and/or fouling, may still be realised with a discontinuous arrangement of amorphous carbon. Indeed, a discontinuous arrangement may allow a thicker carbonaceous layer to be utilised, thus providing enhancements in the mechanical properties of the electrode while still providing excellent proton sensitivity. In such embodiments, carbonaceous layers of up to 500 nm, or even up to 1 micron, in thickness may be suitable.

In some embodiments, the electrode comprises multiple carbonaceous layers at the surface. For example, a thin continuous coating is initially formed over the metal oxide layers, and a thick discontinuous layer is formed thereon for added mechanical protection.

Amorphous carbon layers can be formed by a variety of techniques, as discussed in greater detail hereafter. In some embodiments, the carbonaceous layer is formed by plasma enhanced chemical vapour deposition.

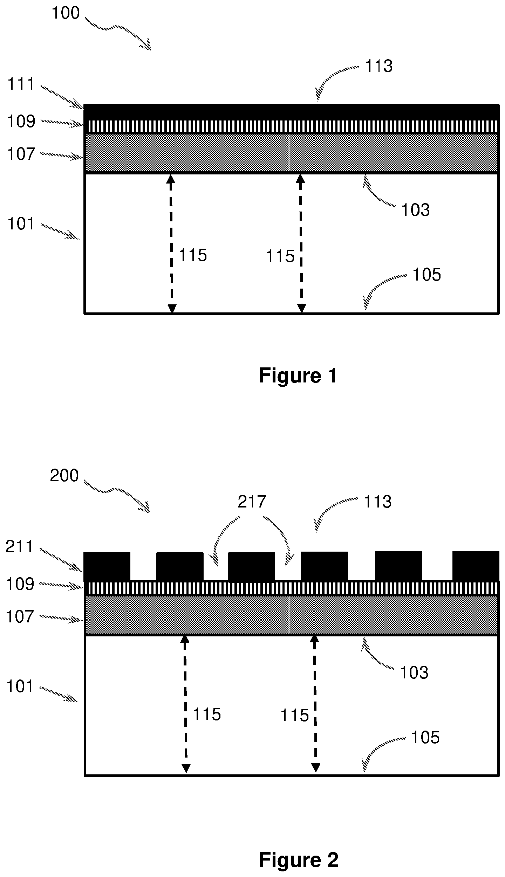

Multi-layered electrode 100, according to an embodiment of the invention, is schematically depicted in Figure 1. Substrate 101 is a doped silicon semiconductor wafer, having first side 103 and second side 105. Sensing layer 107, comprising a proton-sensitive metal oxide such as RuO₂, is a thin film formed on first side 103. Proton-permeable layer 109, comprising an electrically insulating proton-conductive metal oxide such as Ta₂O₅ or YSZ, is a thin, continuous film which uniformly covers sensing layer 107. Carbonaceous layer 111, comprising amorphous carbon such as diamond-like carbon, is a thin continuous film which uniformly covers proton-permeable layer 109. Outer surface 113 of carbonaceous layer 111 thus provides the analyte-contacting surface of the electrode. In use, carbonaceous layer 111 and proton-permeable layer 109 permit conductivity of protons from the analyte to sensing layer 107, while cooperatively excluding interfering oxidising or reducing species from the sensing layer. The insulating proton-permeable metal oxide layer 109 also physically separates sensing layer 107 and carbonaceous layer 111, preventing interference of the measured electrode potential by the carbonaceous layer. The mechanically robust carbonaceous layer advantageously protects the underlying metal-oxide layers from abrasion, and the low surface energy and hydrophobic surface 113 resists attachment and proliferation of foulants including microorganisms. The pH-dependent potential of the multi-layered electrode, attributable to redox reactions of the proton-sensitive metal oxide in sensing layer 107, is measurable via an electrically conductive pathway passing through the thickness of substrate 101, as depicted by arrows 115. The electrode may thus be connected to a potentiometer via an electrical connection on second surface 105.

Multi-layered electrode 200, according to another embodiment of the invention, is schematically depicted in Figure 2. Similarly numbered items of electrode 200 are as described herein for electrode 100. In electrode 200, however, carbonaceous layer 211, comprising amorphous carbon such as diamond-like carbon, is provided as a discontinuous, patterned layer overlying proton-permeable layer 109. For example, it may be a film with regular holes 217 as depicted. Layer 211 may be thicker than layer 111 of electrode 100 due to the discontinuous configuration. The carbonaceous layer 211 is present at the analyte-contacting surface of the electrode, but due to its discontinuous configuration some portions of proton-permeable layer 109 also may be directly exposed to the analyte. In use, proton conductivity from the analyte to sensing layer 107 is provided via at least the holes in carbonaceous layer 211 and through the proton-conductive metal oxide of layer 109. The proton-permeable layer excludes interfering oxidising or reducing species from the proton-sensitive layer. Mechanically robust carbonaceous layer 211 protects the underlying metal-oxide based layers from abrasion, and the low surface energy and hydrophobic surface of the amorphous carbon may still resist fouling of the electrode surface.

### Method of producing a multi-layered electrode

The present invention also relates to a method of producing a multi-layered electrode suitable for sensing pH. The method comprises forming a sensing layer comprising at least one proton-sensitive metal oxide on a substrate, forming a proton-permeable layer comprising at least one electrically insulating proton-conductive metal oxide which covers at least the analyte-contact portion of the proton-sensitive layer, and forming a carbonaceous layer comprising amorphous carbon on the proton-permeable layer. An electrically conductive connection to the sensing layer is provided to allow the measurement of a pH-dependent potential of the multi-layered electrode.

The substrate and the electrically conductive connection are provided as already described herein. The sensing layer, the proton-permeable layer and the carbon layer are preferably thin films, and may thus be formed by a variety of thin-film fabrication techniques.

### Forming the sensing layer and proton-permeable layer

In some embodiments, the sensing layer and/or the proton-permeable layer are formed by sputter deposition. Sputter deposition techniques, and particularly magnetron sputtering, are suitable plasma-based processes for the deposition of a wide range of thin film materials, including metal oxide-based layers according to embodiments of the invention.

In a sputter deposition process, the substrate to be coated and a target source material are separately placed in a low pressure deposition chamber containing an inert gas, typically argon. A negative charge is applied to the target, creating a plasma in the chamber. Positively charged argon ions in the plasma, attracted by the negative charge, collide at high velocity with the source material causing atomic-sized particles of the source material to be "sputtered off". These neutral particles migrate across the deposition chamber and deposit on the substrate as a thin film. In magnetron deposition, magnets are used to retain free electrons in the plasma in the vicinity of the target, preventing them from undesirably bombarding the substrate during coating. Various power sources may be used in sputter deposition processes, including direct current (DC) and radio frequency (RF) power sources. In RF sputtering, the charge of the source is cyclically varied (at radio frequencies) through positive and negative cycles, advantageously preventing build-up of positively charged ions on the target surface. RF sputtering is particularly preferred for depositing metal oxide coatings.

In some embodiments, forming the sensing layer comprises depositing the proton-sensitive metal oxide on the substrate by magnetron sputtering, such as RF magnetron sputtering. The proton-sensitive metal oxide may be any of those described herein as suitable for the electrodes of the invention. The target source material may suitably be a metal or metal oxide comprising the metal to be deposited as the proton-sensitive metal oxide. Thus, for example, a RuO₂ layer may be deposited using either a ruthenium metal or RuO₂ target. Oxygen is co-fed with argon at a controllable ratio to the chamber to provide the thin film in the desired RuO₂ phase.

The sputtering deposition may be conducted at high temperatures, such as above 150°C or between 150°C and 250°C. High temperature sputter deposition may advantageously produce a crystalline metal oxide sensing layer. For example, crystalline RuO₂ thin films of controllable thickness may be formed with either DC or RF power sources, and using both Ru metal or RuO₂ sources. The thickness may be controlled by the deposition time. However, sputtering deposition may also be conducted at lower temperatures such as room temperature, which may result in an amorphous metal oxide sensing layer. Amorphous sensing layers are also suitable for pH measurement, and a low temperature process may advantageously allow the electrode to be fabricated on a heat-sensitive substrate, such as a polymer.

In some embodiments, forming the proton-permeable layer comprises depositing the electrically insulating proton-conductive metal oxide on the substrate by magnetron sputtering, such as RF magnetron sputtering. The proton-conductive metal oxide may be any of those described herein as suitable for the electrodes of the invention. The target source material may suitably be a metal or metal oxide comprising the metal(s) to be deposited as the proton-conductive metal oxide. Thus, for example, a Ta₂O₅ layer may be deposited using either a tantallum metal or Ta₂O₅ target, with oxygen again co-fed to the chamber as needed to deposit the Ta₂O₅ phase. The deposition temperature may be low enough such that the proton-conductive metal oxide is amorphous. For example, an amorphous Ta₂O₅ layer may be deposited at room temperature.

While sputter deposition techniques are particularly preferred, it is also envisaged that the sensing and proton-permeable layers may be formed by other techniques. Such techniques may include: plasma enhanced chemical vapor deposition (PECVD), plasma-enhanced and thermal atomic layer deposition (ALD), filtered vacuum cathodic arc deposition (FVCAD), plasma ion assisted deposition, ion beam sputtering, chemical vapour deposition and sol gel deposition.

### Forming the carbonaceous layer

Thin film carbonaceous layers may be formed by a variety of thin film fabrication techniques. These may include mass selected ion beam (MSIB) deposition, filtered cathodic vacuum arc (FCVA) and laser ablation, used to produce low hydrogen amorphous carbon layers, and plasma enhanced chemical vapour deposition (PECVD) or reactive sputtering of graphite in Ar/H₂, which techniques produce more hydrogenated forms of amorphous carbon. Other suitable techniques and variants include chemical vapour deposition (CVD), plasma-assisted chemical vapour deposition (PACVD), inductively coupled plasma (ICP) PECVD, pulsed DC chemical vapour deposition, hot filament assisted PECVD, electron cyclotron wave resonance (ECWR) plasma beam deposition, microwave chemical vapour deposition, cathodic vacuum arc deposition, ion beam sputtering, RF and DC magnetron sputtering, pulsed-laser deposition (PLD), electrophoretic deposition and sol gel deposition.

In some embodiments, the carbonaceous layer is formed by plasma enhanced chemical vapour deposition. The substrate to be coated is placed on an electrode (substrate holder) inside a vacuum chamber with controllable pressure. An RF power supply is used to apply an RF oscillating voltage to the electrode which generates a plasma inside the vacuum chamber. Inert and reaction gases are introduced into the chamber at a controlled flow rate, while maintaining a target pressure. During deposition, the plasma transfers energy to the gas mixture by electron impact, which initiates ionisation and dissociation of the gas molecules. These species are then transported to the substrate by diffusion, where they adsorb onto the surface into a conformal thin film coating. A hydrocarbon gas such as acetylene (C₂H₂) may suitably be used as the reactant gas.

The thickness of the film may be controlled via the deposition time during plasma enhanced chemical vapour deposition. This technique generally produces a continuous coating of amorphous (diamond-like) carbon on the substrate. For embodiments where a discontinuous carbonaceous layer is desired, this can be achieved using techniques such as lithography or by using a shadow mask (e.g. a mask with holes in it) during the deposition of the carbonaceous layer.

### pH sensor and method of measuring pH

The present invention also relates to a pH sensor, and in particular a potentiometric pH sensor. The pH sensor comprises a multi-layered electrode as disclosed herein, a reference electrode, and means for measuring the difference between the pH-dependent potential of the multi-layered electrode and a reference potential of the reference electrode.

The means for measuring potential difference may be a potentiostat, a voltmeter or the like. The potentiostat (or other device for measuring potential) is coupled to the electrode such that it measures the pH-dependent potential via the electrically conductive connection to the sensing layer. In embodiments where the electrode substrate is conductive, the potentiostat may be electrically connected to the substrate, for example on the reverse side of a semiconductive wafer substrate.

The reference electrode is not considered to be particularly limited, and may for example comprise a standard commercial reference electrode such as a saturated calomel electrode (SCE) or Ag/AgCl electrode containing an internal liquid electrolyte reservoir. In some embodiments, however, the reference electrode may be a solid state reference electrode, for example comprising an Ag/AgCl reference element embedded in a polymeric composite loaded with an inorganic chloride salt. An example of such a reference electrode is disclosed in the applicant's co-pending PCT application published as WO2018/201200, which is hereby incorporated by reference. Such reference electrodes, like embodiments of the multi-layered pH sensing electrodes of the present invention, are well suited for use in acidic and/or abrasive analytes.

The present invention also relates to a method of measuring pH. The method comprises contacting the multi-layered electrode as disclosed herein and a reference electrode with an analyte, and measuring the difference between the pH-dependent potential of the multi-layered electrode and a reference potential of the reference electrode. The electrode may be contacted with the analyte by immersion therein.

The method may be used to measure the pH of a wide variety of analytes, for example those produced in the food industry, chemicals industry, minerals processing, bioprocessing and environmental monitoring. As described herein, advantages of the multi-layered electrodes of the invention may include resistance to interference by reducing or oxidising species and compatibility with corrosively acidic, mechanically abrasive or biofouling analytes. In some embodiments, the analyte contains abrasive particulate material. In some embodiments, the analyte has a pH of below 4, or below 2, or below 1. In some embodiments, the analyte is a process stream from a minerals processing operation, such as heap leaching, including leachate and leach slurries, or an acid mine drainage stream. In other embodiments, the analyte is wastewater with varying ORP levels and the potential for bacterial growth. In other embodiments, the analyte is groundwater or surface water with varying ORP levels and the potential to foul or scale surfaces.

### EXAMPLES

The present invention is described with reference to the following examples. It is to be understood that the examples are illustrative of and not limiting to the invention described herein.

### Materials and techniques

Silicon wafers, N100 prime antimony doped, having a thickness of 500 to 50 µm and a resistivity of 0.05 to 0.20 ohm.com, were obtained from Silicon Wafer Enterprises, LLC, CA, USA.

Thin films of metal oxides were deposited by radio frequency (RF) or direct current (DC) magnetron sputtering using an axial turret magnetron head and power supply (AJA DCXS-750). The sputter targets selected were Ru, RuO₂, Ta₂O₅ and yttrium-stabilized zirconia (ZSZ). The nominal size of the sputter targets was 2 inches and high purity (> 99.0 %). The turret head was mounted vertically in the bottom of the vacuum system. Thickness of the deposited thin films was determined using a surface profiler Dektak 3030.

A ZEISS Auriga scanning electron microscopy SEM / FIB (Focused Ion Beam) microscope was used for scanning electron microscopy analysis. X-Ray diffraction patterns were measured with Cu Kα radiation on a Philips PANalytical X' Pert PRO diffractometer operated at 40 kV and 45 mA. Raman spectroscopy was performed using a Renishaw In Via confocal Raman microscope system. Raman scattering was measured in air, using a He-Ne laser (633 nm) as the excitation light at an incident power of 1Mw and with a spot diameter of 1 µm. The laser beam was focused onto the analysed surface using a microscope objective lens (×20). For X-ray photoelectron spectroscopy (XPS) analysis, the electron binding energy (BE) of the core excitations generated by Mg Kα (1256.6 eV) radiation was analysed with a hemispherical analyser (SPECS 150). The energy resolution of the spectrometer was 0.8 eV for the analyser pass energy of 20 eV. The analysis was performed in ultrahigh vacuum of 1x10⁻⁷ Pa. The area of analysis was approximately 5.0 mm². The XPS system operated with Mg Kα X-ray source (10 keV and 10 mA). The spectra were analysed with CasaXPS 2.3.12 program. The peaks were calibrated against the main C 1s peak at 284.6 eV.

All the electrochemical testing was done in commercial buffer solutions (Merck) using Metrohm Autolab PGSTAT302N potentiostat or Keysight U1231A multichannel system. All electrode potentials were recorded versus commercial SCE or Ag/AgCl (sat.) reference electrodes.

### Example 1. Preparation of electrodes

A 4 inch silicon wafer was diced into 25 mm x 25 mm pieces. The wafer pieces were then prepared by successive steps of ultrasonication in an acetone bath for 15 minutes, ultrasonication in an ethanol bath for 15 minutes, drying under nitrogen, and irradiation with UV light for 15 minutes.

The silicon wafer pieces were then loaded into the deposition chamber of the magnetron, and the chamber was evacuated overnight to reach a base pressure of 2 x 10⁻⁶ mbar. RuO₂ thin film layers were then deposited on the wafers by RF or DC magnetron sputtering, using the conditions set out in Table 1.

**Table 1.**

| Sensing layer method | Power source | Power (W) | Ar/O₂ | Temp (°C) | Deposition Pressure (Pa) | Thickness (nm) | Cathode material |
|---|---|---|---|---|---|---|---|
| S1 | RF | 125 | 4.2 | 220 | 1.65 | 250-500 | Ru |
| S2 | RF | 125 | 3.0 | 220 | 1.65 | 250-500 | RuO₂ |
| S3 | RF | 125 | 4.2 | room T | 1.65 | 250-500 | RuO₂ |
| S4 | DC | 100 | 10 | 220 | 2.0 | 250-350 | RuO₂ |
| S5 | DC | 100 | 10 | 220 | 2.0 | 250-350 | RuO₂ |

Method S5 was the same as S4, except that a discontinuous layer of RuO₂ was deposited using a mask. The layer comprised a square array of 2 µm x 2 µm square blocks of RuO₂ which covered approximately 45% of the underlying Si surface.

The RuO₂ sputter-coated wafers were then coated with a thin film of Ta₂O₅ or yttrium stabilized zirconia (YSZ) by RF magnetron sputtering, using the conditions set out in Table 2.

**Table 2.**

| Proton-permeable layer method | Metal oxide | Power source | Power (W) | Ar/O₂ | Temp (°C) | Deposition Pressure (Pa) | Thickness (nm) | Cathode material |
|---|---|---|---|---|---|---|---|---|
| P1 | Ta₂O₅ | RF | 100 | 16 | room T | 1.0 | 15-60 | Ta₂O₅ |
| P2 | YSZ | RF | 100 | 22 | room T | 0.8 | 15-100 | YSZ |

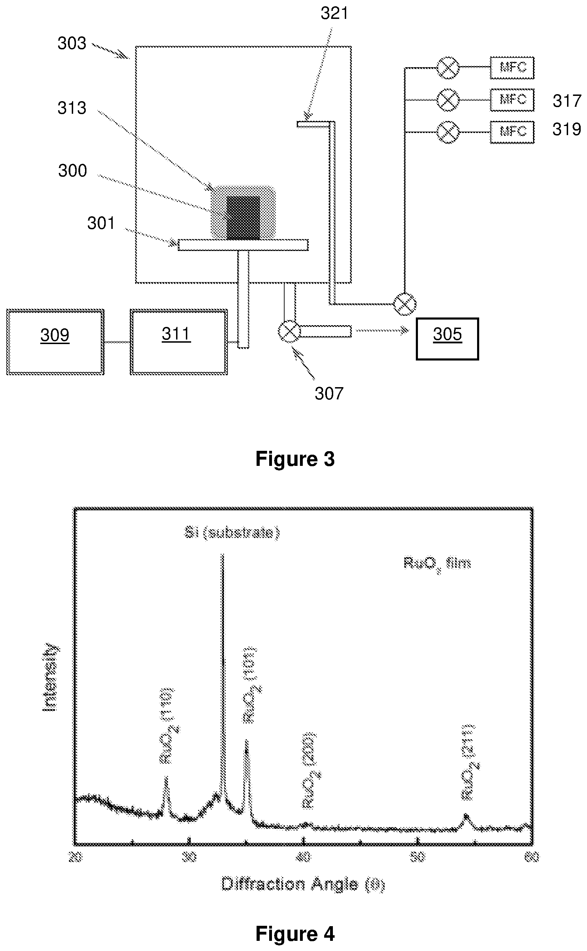

Metal oxide coated wafers were further coated with a layer of diamond-like carbon by plasma enhanced chemical vapour deposition (PECVD). A substrate 300 was placed onto an electrode (substrate holder) 301 inside a vacuum chamber 303 of a deposition apparatus, as schematically depicted in Figure 3. The chamber was evacuated via vacuum pump 305, with the pressure controllable via throttle valve 307. A radio frequency (RF) power supply 309 with matching network 311 was used to apply an **RF** oscillating voltage to the electrode, thus generating plasma 313 inside the vacuum chamber. Gases, including argon 317 and acetylene 319, were introduced into the chamber via gas inlet pipe 321, using mass flow controllers to provide a controlled flow rate. During deposition, the plasma transfers energy to the gas mixture by electron impact, which initiates ionisation and dissociation of the gas molecules. The gas reactants are then transported to the substrate by diffusion and adsorb onto the surface into a conformal thin film coating. Diamond-like carbon coatings were thus deposited using the conditions set out in Table 3.

**Table 3.**

| Carbon layer method | Power source | Power (W) | C₂H₂ flow rate (sccm) | Temp (°C) | Deposition Pressure (mTorr) | Thickness (nm) |
|---|---|---|---|---|---|---|
| C1 | RF | 200 | 100 | room T | 50 | 30-500 |

Once coated with the RuO₂, Ta₂O₅ / YSZ and/or diamond-like carbon layers, the coated substrates were diced into 6 mm x 6 mm pieces. The resulting electrodes are identified hereafter according to the configuration of layers on Si substrate as designated in Tables 1-3, for example Si-S1-P1-C1 for a multi-layered electrode having all three layers according to the invention. The samples were examined using an optical microscope, and resistivity measurements were performed to determine that the surface is insulating. The electrodes were then ready for characterisation or assembly into a pH sensing device.

For electrochemical testing, a wire was connected to the uncoated side of the silicon wafer using electrically conductive silver epoxy. The electrodes were then placed in a casing with opening area of 5 mm. The electrodes were glued using epoxy (Struers) and the electrical connection was potted using the same epoxy. The electrodes were connected to a potentiostat (Metrohm Autolab PGSTAT302N potentiostat) together with a reference electrode (standard laboratory SCE) for the electrochemical testing.

### Example 2. Characterisation of the electrodes

The crystallinity of the RuO₂ sputter coated thin films was investigated by scanning electron microscopy and X-Ray diffraction. SEM images of films deposited at 250°C (Si-S1) were observed to be crystalline, while those deposited at room temperature (Si-S3) were observed to be amorphous. The results were confirmed with X-Ray diffraction. For example, the X-Ray diffraction pattern depicted in Figure 4 confirms that RuO₂ thin film deposited at 250°C (Si-S1) was highly crystalline. Analysis of the RuO₂ thin films by Raman spectroscopy was consistent with reported literature data.

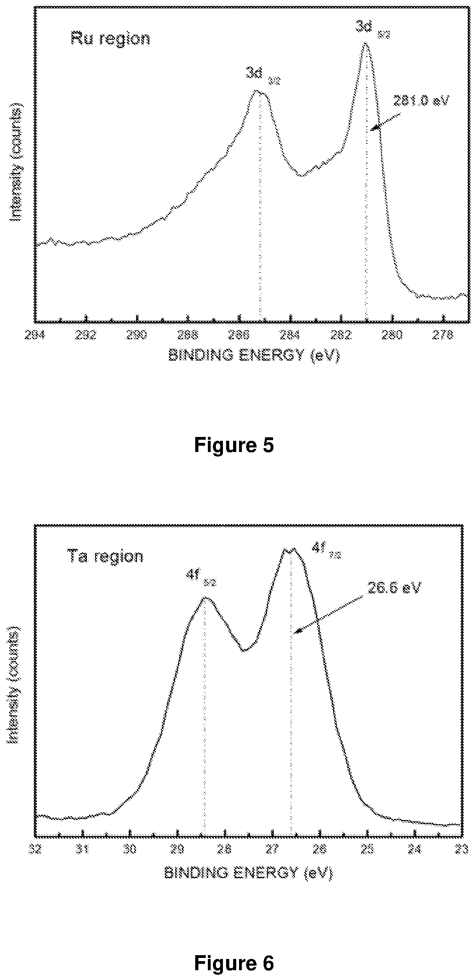

The chemical composition and chemical state of the surfaces of the RuO₂ and Ta₂O₅ thin films were analysed using XPS. Representative spectra of Si-S1 and Si-S1-P1 electrodes are depicted in Figures 5 and 6 respectively. The spectra showed that the surface composition is 2:1 (oxygen to Ru) in the RuO₂ films, indicating that the films are of RuO₂ phase and no contaminating elements were detected. The binding energy position in the Ru region confirmed the RuO₂ phase and is in agreement with published data. For the tantalum oxide film, the binding position of the peaks confirmed the pentoxide (Ta₂O₅) phase. No RuO₂ peaks were observed for the Si-S1-P1 electrode, indicating that a consistent coverage of Ta₂O₅ over the RuO₂ layer was provided. This was confirmed by ion scattering spectroscopy, a very sensitive surface-analysis technique, where again the underlying RuO₂ layer could not be detected.

### Example 3. Electrodes with different RuO₂ layers

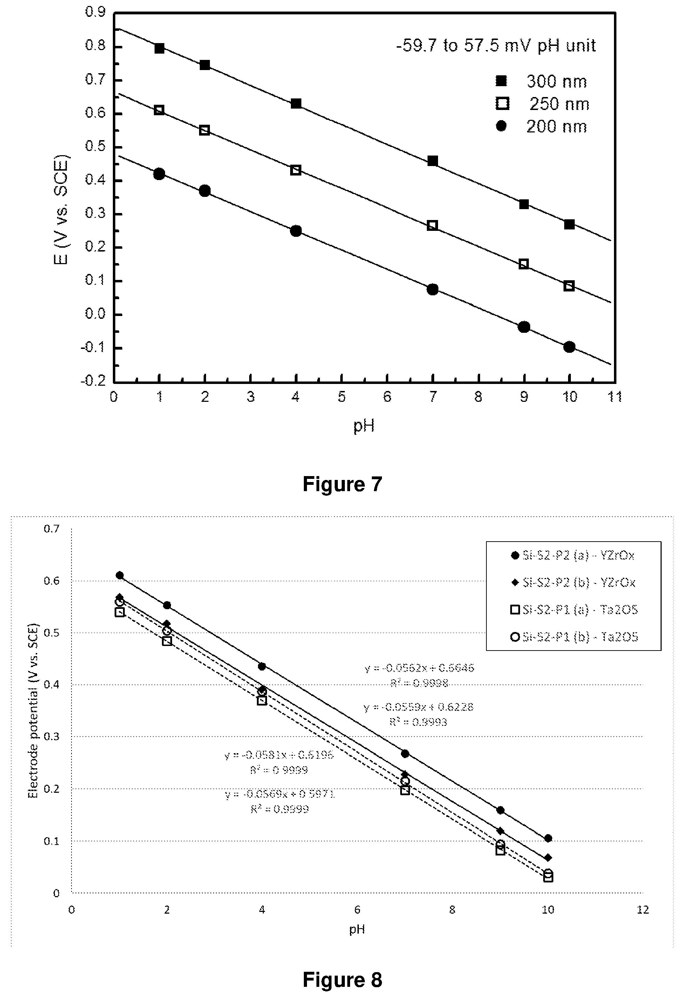

The pH responsiveness of the thin-film coated electrodes was evaluated in pH buffer solutions of known pH values from 1 to 10. Figure 7 depicts plots of electrode potential as a function of pH for Si-S2-P1 electrodes having various different RuO₂ film thicknesses. It can be seen that the response is highly linear for film thicknesses of 200, 250 and 300 nm. Extended tests in buffer solutions having pH values of 2 and 7 indicated that the electrodes provide a stable potential reading for at least 4.5 months.

The pH response of an electrode with amorphous RuO₂ layer, i.e. Si-S3-P1, was also evaluated in the pH range 2 to 10. The response was again highly linear, with sensitivity of -50.2 mV/pH (R²=0.99).

### Example 4. Choice of proton-conductive metal oxides

Different metal oxides were investigated for use in the proton-permeable layer. Electrodes Si-S2-P1 and Si-S2-P2 were thus prepared as described in Example 1, having thin film layers of Ta₂O₅ and yttrium stabilized zirconia (30 nm thickness) deposited on the RuO₂ layer respectively. The pH responsiveness of the thin-film coated electrodes was evaluated in pH buffer solutions of known pH values from 1 to 10. Figure 8 depicts plots of electrode potential as a function of pH for both electrodes in duplicate. It can be seen that both electrodes displayed a highly linear, Nernstian response with good sensitivity.

### Example 5. pH response of RuO₂ + Ta₂O₅ + diamond-like carbon electrodes

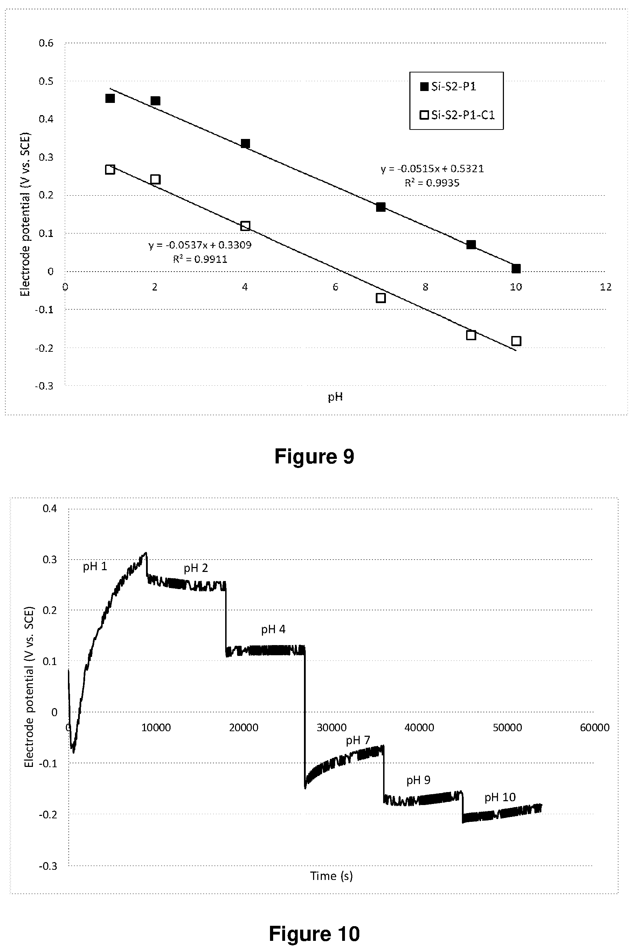

The effect of the diamond-like carbon layer on electrode performance was evaluated in pH buffer solutions of known pH values from 1 to 10. Figure 9 depicts comparative plots of electrode potential as a function of pH for a Si-S2-P1-C1 electrode with 250 nm thick RuO₂ layer, 30 nm thick Ta₂O₅ layer and 50 nm thick diamond-like carbon coating, and the equivalent unprotected Si-S2-P1 electrode. It can be seen that the carbon-coated electrode maintains a linear pH response with similar sensitivity. Figure 10 depicts the electrode potential response of the Si-S1-P1-C1 electrode in the pH 1 to pH 10 buffer solutions as a function of time. The results show good sensitivity and rapid response to changes in pH.

### Example 6. Sensitivity of RuO₂ + Ta₂O₅ + diamond-like carbon electrodes to interference

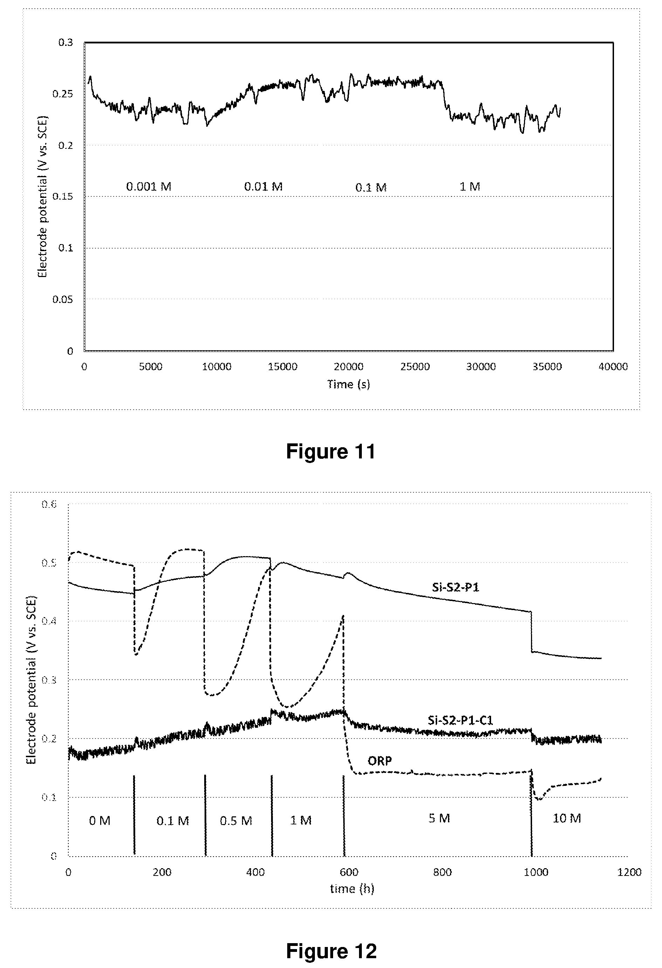

The sensitivity of the Si-S2-P1-C1 electrode (same layer thicknesses as in Example 4) to reducing species was evaluated by measuring the potential response in pH 2 buffer solutions with Fe²⁺ concentrations varying from 0.001M to 1 M. The results are depicted in Figure 11. It is evident that the potential was stable across a wide range of reductant concentrations.

The sensitivity of the Si-S2-P1-C1 electrode (same layer thicknesses as in Example 4) to another reducing species was evaluated by measuring the potential response in pH 2 buffer solutions with ascorbic acid concentrations varying from 0 M to 10 M. In this experiment, the potential of an ORP electrode (Pt) was also measured. The results are depicted in Figure 12, with comparison against an equivalent Si-S2-P1 electrode (i.e. lacking the diamond-like carbon coating). Both electrodes showed good potential stability despite the presence of varying ascorbic acid, with the diamond-like carbon coated Si-S2-P1-C1 electrode providing a superior result. The Ta₂O₅ layer, assisted by the diamond-like carbon layer when present, protects the RuO₂ layer from interference by the reducing agents. By comparison, electrodes with only an unprotected RuO₂ layer were very sensitive to interference by reducing agents.

### Example 7. Role of the proton-permeable layer

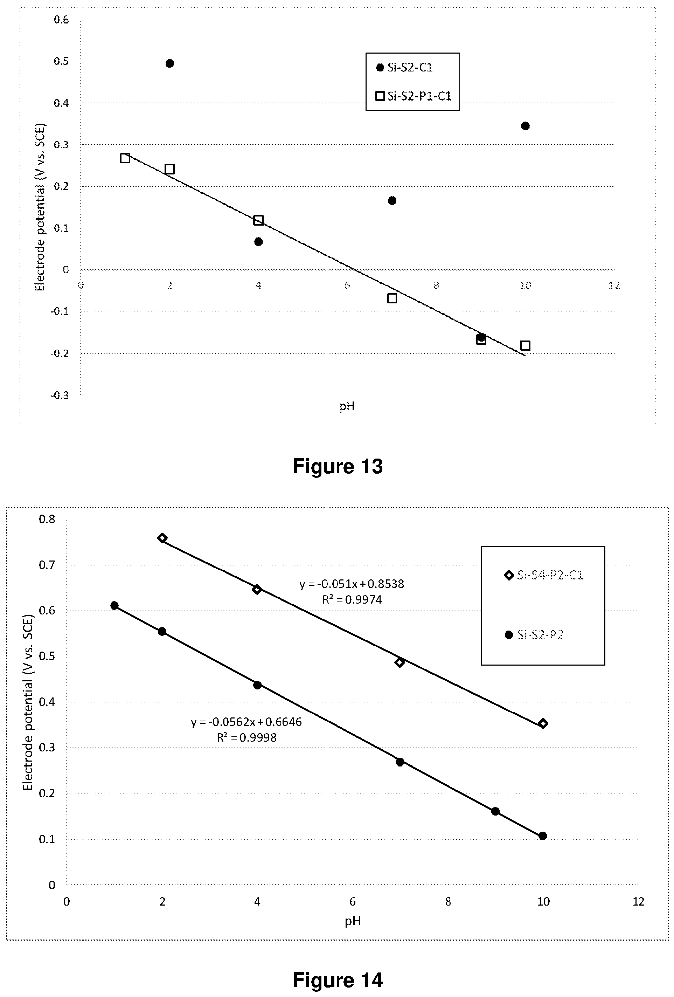

The role of the Ta₂O₅ layer on electrode performance was investigated. Figure 13 depicts comparative plots of electrode potential as a function of pH for a SiS2-P1-C1 electrode with 250 nm thick RuO₂ layer, 30 nm thick Ta₂O₅ layer and 50 nm thick diamond-like carbon coating, and the equivalent Si-S2-C1 electrode which lacked the intermediate Ta₂O₅ layer. The Si-S2-P1-C1 electrode provided a linear pH response. However, there was no clear correlation between pH and electrode potential for the S1-S2-C1 electrode. The same result was obtained in duplicate experiments. It is believed that the intermediate electrically insulating Ta₂O₅ layer, which physically and electrically isolates the pH-sensitive RuO₂ layer from the diamond-like carbon layer, is required to prevent interference of the measured potential by the diamond-like carbon layer.

### Example 8. pH response of RuO₂ + yttrium stabilized zirconia + diamond-like carbon electrodes

The effect of the diamond-like carbon layer on electrode performance, with an intermediate yttrium stabilized zirconia (YSZ) layer, was evaluated in pH buffer solutions of known pH values from 2 to 10. Figure 14 depicts comparative plots of electrode potential as a function of pH for a Si-S4-P2-C1 electrode with 300 nm thick RuO₂ layer, 50 nm thick YSZ layer and 50 nm thick diamond-like carbon coating, and the Si-S2-P2 electrode lacking a protective carbon layer. It can be seen that the carbon-coated electrode maintains a linear pH response with similar sensitivity to the unprotected electrode.

### Example 9. Configuration of the RuO₂ sensing layer

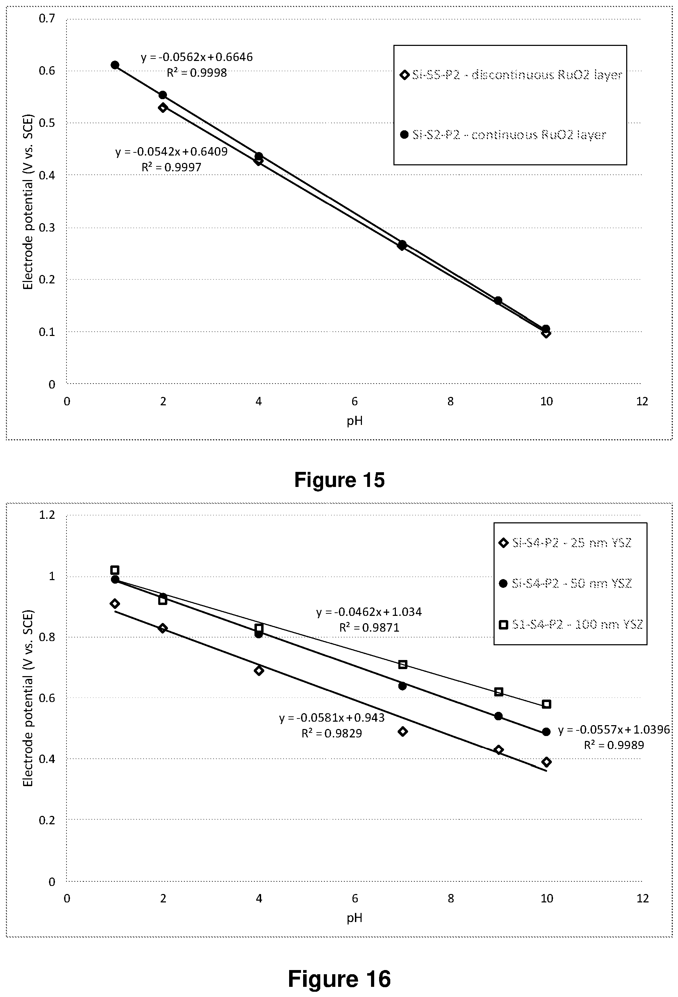

The effect of the configuration of the sensing layer was investigated by comparing electrodes with continuous and discontinuous RuO₂ sensing layers. Figure 15 depicts comparative plots of electrode potential as a function of pH for a Si-S2-P2 electrode with 250 nm thick continuous RuO₂ layer covered by a continuous 30 nm thick YSZ layer, and a Si-S5-P2 electrode with 250 nm thick discontinuous RuO₂ layer (square array of unconnected 2 µm x 2 µm square blocks) covered by a continuous 50 nm thick YSZ layer. It can be seen that both electrodes provide a linear pH response with similar sensitivity, demonstrating that the sensing layer is not required to be continuous.

### Example 10. Thickness of the proton-permeable yttrium stabilized zirconia layer

The effect of the proton-permeable layer thickness was investigated for the case where YSZ was used as the proton-conductive metal oxide. Figure 16 depicts comparative plots of electrode potential as a function of pH for Si-S4-P2 electrodes with YSZ layers of 25, 50 and 100 nm overlying a 300 nm thick RuO₂ layer. It can be seen that a linear pH response was obtained in each case, with only a minor loss of sensitivity encountered with the thickest layer of YSZ. The thicker layers of YSZ may thus provide improved protection of the underlying RuO₂ layer with little consequential loss of selectivity.

## Claims

1. A multi-layered electrode (100, 200) for sensing pH, the electrode comprising:
a sensing layer (107) on a substrate (101), the sensing layer (107) comprising at least one proton-sensitive metal oxide, wherein a pH-dependent potential of the multi-layered electrode (100, 200) is measurable via an electrically conductive connection to the sensing layer (107);
a proton-permeable layer (109) covering at least a portion of the sensing layer (107), the proton-permeable layer (109) comprising at least one electrically insulating proton-conductive metal oxide; the multi-layered electrode (100, 200) being **characterised in that** it further comprises
a carbonaceous layer (111, 211) on the proton-permeable layer (109), the carbonaceous layer comprising amorphous carbon.

2. The multi-layered electrode (100, 200) according to claim 1, wherein the carbonaceous layer (111, 211) is a continuous coating which covers at least a portion of the proton-permeable layer.

3. The multi-layered electrode (100, 200) according to claim 1 or claim 2, wherein the carbonaceous layer (111, 211) has a thickness of less than 500 nm.

4. The multi-layered electrode (100, 200) according to any one of claims 1 to 3, wherein the amorphous carbon comprises diamond-like carbon.

5. The multi-layered electrode (100, 200) according to any one of claims 1 to 4, wherein:
(i) the amorphous carbon comprises at least 10 % sp³-hybridised carbon of the total carbon; and/or
(ii) the carbonaceous layer (111, 211) is formed by plasma enhanced chemical vapour deposition.

6. The multi-layered electrode (100, 200) according to any one of claims 1 to 5, wherein the proton-conductive metal oxide is selected from the group consisting of tantalum pentoxide, yttrium stabilised zirconia, yttrium-doped barium cerate, barium cerium yttrium zirconate and gadolinium oxide doped cerium oxide; and/or
the proton-sensitive metal oxide is selected from the group consisting of ruthenium oxide (RuO₂), platinum oxide (PtO₂), iridium oxide (IrO₂), osmium oxide (OsO₂), tin oxide (SnO₂), titanium oxide (TiO₂), antimony oxide (Sb₂O₃), rhodium oxide (RhO₂), and palladium oxide (PdO).

7. The multi-layered electrode (100, 200) according to any one of claims 1 to 6, wherein:
(i) the substrate (101) comprises an electrically conductive material such that the electrically conductive connection passes through or along the substrate, wherein the electrically conductive material preferably comprises a semiconductor; and/or
(ii) the substrate (101) comprises a semiconductor wafer having a first side, a second side and a thickness of between 300 µm and 3 mm, wherein the sensing layer (107) is disposed on the first side and the pH-dependent potential of the multi-layered electrode (100, 200) is measurable through the second side.

8. The multi-layered electrode (100, 200) according to any one of claims 1 to 7, wherein:
(a) the sensing layer (107) has a thickness of between 200 nm and 1000 nm;
(b) the proton-permeable layer (109) has a thickness of between 10 nm and 100 nm;
(c) the sensing layer (107) and the proton-permeable layer (109) are formed by sputtering;
(d) the proton-sensitive metal oxide comprises ruthenium oxide; and/or
(e) the proton-conductive metal oxide comprises tantalum pentoxide or yttrium stabilized zirconia.

9. A pH sensor, comprising the multi-layered electrode (100, 200) according to any one of claims 1 to 8, a reference electrode, and means for measuring the difference between the pH-dependent potential of the multi-layered electrode (100, 200) and a reference potential of the reference electrode.

10. A method of measuring pH, the method comprising:
contacting the multi-layered electrode (100, 200) according to any one of claims 1 to 8 and a reference electrode with an analyte; and
measuring the difference between the pH-dependent potential of the multi-layered electrode (100, 200) and a reference potential of the reference electrode.

11. The method according to claim 10, wherein:
(i) the analyte comprises abrasive particulate material and/or has a pH of below 4; and/or
(ii) the analyte is a leachate or a leach slurry from a mineral leaching process or an acid mine drainage stream.

12. A method of producing a multi-layered electrode (100, 200) for sensing pH, the method comprising:
forming a sensing layer (107) on a substrate (101), the sensing layer (107) comprising at least one proton-sensitive metal oxide;
forming a proton-permeable layer (109) covering at least a portion of the proton-sensitive layer (107), the proton-permeable layer (109) comprising at least one electrically insulating proton-conductive metal oxide;
forming a carbonaceous layer (111, 211) on the proton-permeable layer (109), the carbonaceous layer (111, 211) comprising amorphous carbon; and
providing an electrically conductive connection to the sensing layer (107) for measuring a pH-dependent potential of the multi-layered electrode (100, 200).

13. The method according to claim 12, wherein:
(i) forming the carbonaceous layer (111, 211) comprises depositing amorphous carbon on the proton-permeable layer (109) by plasma enhanced chemical vapour deposition; and/or
(ii) forming the sensing layer (107) comprises depositing the proton-sensitive metal oxide on the substrate (101) by sputtering.

14. The method according to claim 12 or claim 13, wherein:
(a) forming the proton-permeable layer (109) comprises depositing the proton-conductive metal oxide on the sensing layer (107) by sputtering;
(b) the substrate (101) comprises a conductive material such that the electrically conductive connection passes through or along the substrate (101); and/or
(c) the substrate (101) comprises a semiconductor wafer having a first side, a second side and a thickness of between 300 µm and 3 mm, wherein the sensing layer (107) is formed on the first side.

15. The method according to any one of claims 12 to 14, wherein the proton-conductive metal oxide is selected from the group consisting of tantalum pentoxide, tantalum pentoxide, yttrium stabilised zirconia, yttrium-doped barium cerate, barium cerium yttrium zirconate and gadolinium oxide doped cerium oxide; and/or
the proton-sensitive metal oxide is selected from the group consisting of ruthenium oxide (RuO₂), platinum oxide (PtO₂), iridium oxide (IrO₂), osmium oxide (OsO₂), tin oxide (SnO₂), titanium oxide (TiO₂), antimony oxide (Sb₂O₃), rhodium oxide (RhO₂), and palladium oxide (PdO).

## Patentansprüche

1. Mehrschichtige Elektrode (100, 200) zum pH-Messen, wobei die Elektrode umfasst:
eine Sensorschicht (107) auf einem Substrat (101), wobei die Sensorschicht (107) mindestens ein protonenempfindliches Metalloxid umfasst, wobei ein pH-abhängiges Potential der mehrschichtigen Elektrode (100, 200) über eine elektrisch leitende Verbindung mit der Sensorschicht (107) messbar ist;
eine protonendurchlässige Schicht (109), die mindestens einen Teil der Sensorschicht (107) bedeckt, wobei die protonendurchlässige Schicht (109) mindestens ein elektrisch isolierendes protonenleitendes Metalloxid umfasst;
wobei die mehrschichtige Elektrode (100, 200) dadurch charakterisiert ist, dass sie ferner eine kohlenstoffhaltige Schicht (111, 211) auf der protonendurchlässigen Schicht (109) umfasst, wobei die kohlenstoffhaltige Schicht amorphen Kohlenstoff umfasst.

2. Mehrschichtige Elektrode (100, 200) gemäß Anspruch 1, wobei die kohlenstoffhaltige Schicht (111, 211) eine kontinuierliche Beschichtung ist, die mindestens einen Teil der protonendurchlässigen Schicht bedeckt.

3. Mehrschichtige Elektrode (100, 200) gemäß Anspruch 1 oder Anspruch 2, wobei die kohlenstoffhaltige Schicht (111, 211) eine Dicke von weniger als 500 nm aufweist.

4. Mehrschichtige Elektrode (100, 200) gemäß einem jeglichen der Ansprüche 1 bis 3, wobei der amorphe Kohlenstoff diamantartigen Kohlenstoff umfasst.

5. Mehrschichtige Elektrode (100, 200) gemäß einem jeglichen der Ansprüche 1 bis 4, wobei:
(i) der amorphe Kohlenstoff mindestens 10% sp³-hybridisierten Kohlenstoff des gesamten Kohlenstoffs umfasst; und/oder
(ii) die kohlenstoffhaltige Schicht (111, 211) durch plasmaverstärkte chemische Gasphasenabscheidung gebildet wird.

6. Mehrschichtige Elektrode (100, 200) gemäß einem jeglichen der Ansprüche 1 bis 5, wobei das protonenleitende Metalloxid ausgewählt ist aus der Gruppe, bestehend aus Tantalpentoxid, Yttrium-stabilisiertem Zirkoniumdioxid, Yttrium-dotiertem Bariumcerat, Barium-Cer-Yttrium-Zirkonat und Gadoliniumoxid-dotiertem Ceroxid; und/oder das protonenempfindliche Metalloxid ausgewählt ist aus der Gruppe, bestehend aus Rutheniumoxid (RuO₂), Platinoxid (PtO₂), Iridiumoxid (IrO₂), Osmiumoxid (OsO₂), Zinnoxid (SnO₂), Titanoxid (TiO₂), Antimonoxid (Sb₂O₃), Rhodiumoxid (RhO₂) und Palladiumoxid (PdO).

7. Mehrschichtige Elektrode (100, 200) gemäß einem jeglichen der Ansprüche 1 bis 6, wobei:
(i) das Substrat (101) ein elektrisch leitendes Material umfasst, so dass die elektrisch leitende Verbindung durch das oder entlang dem Substrat (101) verläuft, wobei das elektrisch leitende Material vorzugsweise einen Halbleiter umfasst; und/oder
(ii) das Substrat (101) einen Halbleiterwafer mit einer ersten Seite, einer zweiten Seite und einer Dicke zwischen 300 µm und 3 mm umfasst, wobei die Sensorschicht (107) auf der ersten Seite angeordnet ist und das pH-abhängige Potential der mehrschichtigen Elektrode (100, 200) durch die zweite Seite messbar ist.

8. Mehrschichtige Elektrode (100, 200) gemäß einem jeglichen der Ansprüche 1 bis 7, wobei:
(a) die Sensorschicht (107) eine Dicke zwischen 200 nm und 1000 nm aufweist;
(b) die protonendurchlässige Schicht (109) eine Dicke zwischen 10 nm und 100 nm aufweist;
(c) die Sensorschicht (107) und die protonendurchlässige Schicht (109) durch Sputtern gebildet werden;
(d) das protonenempfindliche Metalloxid Rutheniumoxid umfasst; und/oder
(e) das protonenleitende Metalloxid Tantalpentoxid oder Yttrium-stabilisiertes Zirkoniumdioxid umfasst.

9. pH-Sensor, umfassend die mehrschichtige Elektrode (100, 200) gemäß einem jeglichen der Ansprüche 1 bis 8, eine Referenzelektrode und Mittel zum Messen der Differenz zwischen dem pH-abhängigen Potential der mehrschichtigen Elektrode (100, 200) und einem Referenzpotential der Referenzelektrode.

10. Verfahren zum pH-Messen, wobei das Verfahren umfasst:
In-Kontakt-Bringen der mehrschichtigen Elektrode (100, 200) gemäß einem jeglichen der Ansprüche 1 bis 8 und einer Referenzelektrode mit einem Analyten; und
Messen der Differenz zwischen dem pH-abhängigen Potential der mehrschichtigen Elektrode (100, 200) und einem Referenzpotential der Referenzelektrode.

11. Verfahren gemäß Anspruch 10, wobei:
(i) der Analyt abrasives partikuläres Material umfasst und/oder einen pH-Wert von unter 4 aufweist; und/oder
(ii) der Analyt ein Sickerwasser oder eine Sickerwasseraufschlämmung aus einem Mineralauslaugungsverfahren oder einem sauren Grubenwasserstrom ist.

12. Verfahren zum Herstellen einer mehrschichtigen Elektrode (100, 200) zum pH-Messen, wobei das Verfahren umfasst:
Bilden einer Sensorschicht (107) auf einem Substrat (101), wobei die Sensorschicht (107) mindestens ein protonenempfindliches Metalloxid umfasst;
Bilden einer protonendurchlässigen Schicht (109), die mindestens einen Teil der protonenempfindlichen Schicht (107) bedeckt, wobei die protonendurchlässige Schicht (109) mindestens ein elektrisch isolierendes, protonenleitendes Metalloxid umfasst;
Bilden einer kohlenstoffhaltigen Schicht (111, 211) auf der protonendurchlässigen Schicht (109), wobei die kohlenstoffhaltige Schicht (111, 211) amorphen Kohlenstoff umfasst; und
Bereitstellen einer elektrisch leitenden Verbindung mit der Sensorschicht (107) zum Messen eines pH-abhängigen Potentials der mehrschichtigen Elektrode (100, 200).

13. Verfahren gemäß Anspruch 12, wobei:
(i) das Bilden der kohlenstoffhaltigen Schicht (111, 211) ein Abscheiden von amorphem Kohlenstoff auf der protonendurchlässigen Schicht (109) durch plasmaverstärkte chemische Gasphasenabscheidung umfasst; und/oder
(ii) das Bilden der Sensorschicht (107) ein Abscheiden des protonenempfindlichen Metalloxids auf dem Substrat (101) durch Sputtern umfasst.

14. Verfahren gemäß Anspruch 12 oder Anspruch 13, wobei:
(a) das Bilden der protonendurchlässigen Schicht (109) ein Abscheiden des protonenleitenden Metalloxids auf der Sensorschicht (107) durch Sputtern umfasst;
(b) das Substrat (101) ein leitendes Material umfasst, so dass die elektrisch leitende Verbindung durch das oder entlang dem Substrat (101) verläuft; und/oder
(c) das Substrat (101) einen Halbleiterwafer mit einer ersten Seite, einer zweiten Seite und einer Dicke zwischen 300 µm und 3 mm umfasst, wobei die Sensorschicht (107) auf der ersten Seite ausgebildet ist.

15. Verfahren gemäß einem jeglichen der Ansprüche 12 bis 14, wobei das protonenleitende Metalloxid ausgewählt ist aus der Gruppe, bestehend aus Tantalpentoxid, Yttrium-stabilisiertem Zirkoniumdioxid, Yttrium-dotiertem Bariumcerat, Barium-Cer-Yttrium-Zirkonat und Gadoliniumoxid-dotiertem Ceroxid; und/oder das protonenempfindliche Metalloxid ausgewählt ist aus der Gruppe, bestehend aus Rutheniumoxid (RuO₂), Platinoxid (PtO₂), Iridiumoxid (IrO₂), Osmiumoxid (OsO₂), Zinnoxid (SnO₂), Titanoxid (TiO₂), Antimonoxid (Sb₂O₃), Rhodiumoxid (RhO₂) und Palladiumoxid (PdO).

## Revendications

1. Électrode multicouche (100, 200) pour la détection du pH, l'électrode comprenant :
une couche de détection (107) sur un substrat (101), la couche de détection (107) comprenant au moins un oxyde métallique sensible aux protons, dans laquelle un potentiel dépendant du pH de l'électrode multicouche (100, 200) peut être mesuré par l'intermédiaire d'une connexion électriquement conductrice à la couche de détection (107) ;
une couche perméable aux protons (109) recouvrant au moins une partie de la couche de détection (107), la couche perméable aux protons (109) comprenant au moins un oxyde métallique conducteur de protons et électriquement isolant ;
l'électrode multicouche (100, 200) étant **caractérisée en ce qu'**elle comprend en outre une couche carbonée (111, 211) sur la couche perméable aux protons (109), la couche carbonée comprenant du carbone amorphe.

2. Électrode multicouche (100, 200) selon la revendication 1, dans laquelle la couche carbonée (111, 211) est un revêtement continu qui recouvre au moins une partie de la couche perméable aux protons.

3. Électrode multicouche (100, 200) selon la revendication 1 ou la revendication 2, dans laquelle la couche carbonée (111, 211) présente une épaisseur inférieure à 500 nm.

4. Électrode multicouche (100, 200) selon l'une quelconque des revendications 1 à 3, dans laquelle le carbone amorphe comprend du carbone de type diamant.

5. Électrode multicouche (100, 200) selon l'une quelconque des revendications 1 à 4, dans laquelle :
(i) le carbone amorphe comprend au moins 10 % de carbone hybridé sp³ du carbone total ; et/ou
(ii) la couche carbonée (111, 211) est formée par dépôt chimique en phase vapeur assisté par plasma.

6. Électrode multicouche (100, 200) selon l'une quelconque des revendications 1 à 5, dans laquelle l'oxyde métallique conducteur de protons est choisi dans le groupe constitué par le pentoxyde de tantale, la zircone stabilisée à l'yttrium, le cérate de baryum dopé à l'yttrium, le zirconate de baryum-cérium-yttrium et l'oxyde de cérium dopé à l'oxyde de gadolinium ; et/ou l'oxyde métallique sensible aux protons est choisi dans le groupe constitué par l'oxyde de ruthénium (RuO₂), l'oxyde de platine (PtO₂), l'oxyde d'iridium (IrO₂), l'oxyde d'osmium (OsO₂), l'oxyde d'étain (SnO₂), l'oxyde de titane (TiO₂), l'oxyde d'antimoine (Sb₂O₃), l'oxyde de rhodium (RhO₂) et l'oxyde de palladium (PdO).

7. Électrode multicouche (100, 200) selon l'une quelconque des revendications 1 à 6, dans laquelle :
(i) le substrat (101) comprend un matériau électriquement conducteur de sorte que la connexion électriquement conductrice passe à travers ou le long du substrat, ledit matériau électriquement conducteur comprend de préférence un semi-conducteur ; et/ou
(ii) le substrat (101) comprend une plaquette semi-conductrice possédant un premier côté, un second côté et une épaisseur comprise entre 300 µm et 3 mm, ladite couche de détection (107) étant disposée sur le premier côté et le potentiel dépendant du pH de l'électrode multicouche (100, 200) pouvant être mesuré à travers le second côté.

8. Électrode multicouche (100, 200) selon l'une quelconque des revendications 1 à 7, dans laquelle :
(a) la couche de détection (107) présente une épaisseur comprise entre 200 nm et 1000 nm ;
(b) la couche perméable aux protons (109) présente une épaisseur comprise entre 10 nm et 100 nm ;
(c) la couche de détection (107) et la couche perméable aux protons (109) sont formées par pulvérisation cathodique ;
(d) l'oxyde métallique sensible aux protons comprend de l'oxyde de ruthénium ; et/ou
(e) l'oxyde métallique conducteur de protons comprend du pentoxyde de tantale ou de la zircone stabilisée à l'yttrium.

9. Capteur de pH, comprenant l'électrode multicouche (100, 200) selon l'une quelconque des revendications 1 à 8, une électrode de référence et un moyen pour mesurer la différence entre le potentiel dépendant du pH de l'électrode multicouche (100, 200) et un potentiel de référence de l'électrode de référence.

10. Procédé de mesure du pH, le procédé comprenant :
la mise en contact de l'électrode multicouche (100, 200) selon l'une quelconque des revendications 1 à 8 et d'une électrode de référence avec un analyte ; et
la mesure de la différence entre le potentiel dépendant du pH de l'électrode multicouche (100, 200) et un potentiel de référence de l'électrode de référence.

11. Procédé selon la revendication 10, dans lequel :
(i) l'analyte comprend une matière particulaire abrasive et/ou présente un pH inférieur à 4 ; et/ou
(ii) l'analyte est un lixiviat ou une boue de lixiviation provenant d'un processus de lixiviation minérale ou d'un flux de drainage minier acide.

12. Procédé de production d'une électrode multicouche (100, 200) pour détecter le pH, le procédé comprenant :
la formation d'une couche de détection (107) sur un substrat (101), la couche de détection (107) comprenant au moins un oxyde métallique sensible aux protons ;
la formation d'une couche perméable aux protons (109) recouvrant au moins une partie de la couche sensible aux protons (107), la couche perméable aux protons (109) comprenant au moins un oxyde métallique conducteur de protons et électriquement isolant ;
la formation d'une couche carbonée (111, 211) sur la couche perméable aux protons (109), la couche carbonée (111, 211) comprenant du carbone amorphe ; et
la fourniture d'une connexion électriquement conductrice à la couche de détection (107) pour mesurer un potentiel dépendant du pH de l'électrode multicouche (100, 200).

13. Procédé selon la revendication 12, dans lequel :
(i) la formation de la couche carbonée (111, 211) comprend le dépôt de carbone amorphe sur la couche perméable aux protons (109) par dépôt chimique en phase vapeur assisté par plasma ; et/ou
(ii) la formation de la couche de détection (107) comprend le dépôt de l'oxyde métallique sensible aux protons sur le substrat (101) par pulvérisation cathodique.

14. Procédé selon la revendication 12 ou la revendication 13, dans lequel :
(a) la formation de la couche perméable aux protons (109) comprend le dépôt de l'oxyde métallique conducteur de protons sur la couche de détection (107) par pulvérisation cathodique ;
(b) le substrat (101) comprend un matériau conducteur de sorte que la connexion électriquement conductrice passe à travers ou le long du substrat (101) ; et/ou
(c) le substrat (101) comprend une plaquette semi-conductrice possédant un premier côté, un second côté et une épaisseur comprise entre 300 µm et 3 mm, ladite couche de détection (107) étant formée sur le premier côté.

15. Procédé selon l'une quelconque des revendications 12 à 14, dans lequel l'oxyde métallique conducteur de protons est choisi dans le groupe constitué par le pentoxyde de tantale, la zircone stabilisée à l'yttrium, le cérate de baryum dopé à l'yttrium, le zirconate de baryum-cérium-yttrium et l'oxyde de cérium dopé à l'oxyde de gadolinium ; et/ou
l'oxyde métallique sensible aux protons est choisi dans le groupe constitué de l'oxyde de ruthénium (RuO₂), de l'oxyde de platine (PtO₂), de l'oxyde d'iridium (IrO₂), de l'oxyde d'osmium (OsO₂), de l'oxyde d'étain (SnO₂), de l'oxyde de titane (TiO₂), de l'oxyde d'antimoine (Sb₂O₃), de l'oxyde de rhodium (RhO₂) et de l'oxyde de palladium (PdO).
